(19) Europäisches Patentamt
European Patent Office
Office européen des brevets

(11) **EP 4 037 209 A1**

(12) **EUROPÄISCHE PATENTANMELDUNG**

(43) Veröffentlichungstag:
**03.08.2022 Patentblatt 2022/31**

(51) Internationale Patentklassifikation (IPC):
**H04B 17/21** (2015.01)

(21) Anmeldenummer: **22153915.8**

(52) Gemeinsame Patentklassifikation (CPC):
**H04B 17/21**

(22) Anmeldetag: **28.01.2022**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **01.02.2021 DE 102021102204**

(71) Anmelder: **Diehl Metering Systems GmbH**
**90451 Nürnberg (DE)**

(72) Erfinder:
• **Petkov, Hristo**
**90411 Nürnberg (DE)**

• **Schmidt, Christoph**
**90403 Nürnberg (DE)**
• **Kauppert, Thomas**
**90455 Nürnberg (DE)**
• **Gottschalk, Klaus**
**90610 Winkelhaid (DE)**
• **Schröter, Simon**
**91052 Erlangen (DE)**
• **Meyer, Benjamin**
**90419 Nürnberg (DE)**

(74) Vertreter: **Diehl Patentabteilung**
**c/o Diehl Stiftung & Co. KG**
**Stephanstraße 49**
**90478 Nürnberg (DE)**

(54) **VERFAHREN ZUM VERBESSERN DER ANTENNENANPASSUNG**

(57) Die vorliegende Erfindung betrifft ein Verfahren zum Verbessern der Antennenanpassung bei einem bidirektional funkkommunikationsfähigen Knoten (1), insbesondere einer Sensor- und/ oder Aktoreinrichtung, eines Kommunikationsnetzwerkes mit einem mit einer Antenne (3) ausgestatteten Funkmodul (2) mit Sende- (5) und/oder Empfangspfad (6) und einer vorzugsweise energieautarken Energieversorgungseinrichtung (4), insbesondere Batterie. Zur Verbesserung der Empfindlichkeit des Empfängers, der Minimierung des Energieverbrauchs, der Maximierung der abgestrahlten Signalleistung sowie zur Entlastung der Funkkanalbelegung wird mittels einstellbarer Anpassungen (Transformationswege), vorzugsweise mittels einstellbarer Anpassnetzwerke, die Impedanz (Z_Ant) der Antenne (3) auf Basis einer Messung der Rauschleistung im Empfangspfad (6) bestimmt oder zumindest geschätzt.

Fig. 3

**Beschreibung**

Die Erfindung betrifft ein Verfahren nach dem Oberbegriff des Patentanspruchs 1 zum Verbessern der Antennenanpassung eines bidirektional funkkommunikationsfähigen Knotens eines Kommunikationsnetzes, insbesondere einer Sensor- und/ oder Aktoreinrichtung. Die Erfindung betrifft ferner einen Knoten, der gemäß dem erfindungsgemäßen Verfahren betrieben wird.

Technologischer Hintergrund

Die derzeitige Entwicklung in der Kommunikationstechnik geht dahin, stets mehr und mehr Prozessoren, Kommunikationsmodule sowie andere Elektronikkomponenten in Gegenständen des täglichen Gebrauchs zu integrieren. Auch einfache elektrische Geräte des täglichen Gebrauchs sollen in absehbarer Zukunft mit einer Kommunikationsfähigkeit ausgestattet werden. Man erhofft sich durch diese Entwicklung große Chancen für die Wirtschaft, aber auch für das Privatleben. Smarte bzw. intelligente Objekte werden zunehmend mit Informations- und Kommunikationstechnik ausgestattet und an den Cyberspace mit seinen umfangreichen Diensten angebunden. Hierdurch werden alltägliche Gegenstände eine neue Qualität erhalten. Gegenstände können über Sensoren ihre Umgebung wahrnehmen, sich miteinander vernetzen, auf Internetservices zugreifen oder sogar mit Menschen interagieren. Derartige Sensoren sollen als "Knoten" im sogenannten IoT ("Internet of Things") eingesetzt werden. Aktoren können mechanisch oder elektromagnetisch auf derartige Gegenstände einwirken oder diese mit (elektrischen, vorzugsweise digitalen) Steuersignalen beaufschlagen.

Derartige Sensoren bzw. Aktoren sollen möglichst kleinbauend sein. Da ein Netzanschluss oftmals nicht verfügbar ist, müssen sie in der Regel autark mit Batterien, insbesondere in Form von nicht aufladbaren Longlife-Batterien, betrieben werden. Deshalb muss die Funkkommunikation mit möglichst geringem energetischen Aufwand zuverlässig über einen langen Zeitraum betrieben werden können. Das setzt im Funkmodul eine hohe Empfindlichkeit infolge guter Resonanzanpassung der Schaltung an die Antenne voraus. Aufgrund des geringen zur Verfügung stehenden Bauraums bei derartigen Kommunikationsmodulen ist die Antenne zwangsläufig schmalbandig.

Hinzukommt, dass eine mehr und mehr gesteigerte Leistungsfähigkeit in Bezug auf das Generieren und Versenden von Daten gefordert wird, mit der Folge, dass gleichzeitig der Energieverbrauch der Geräte zunehmen wird. Die Technologie im Bereich der Speicherung von elektrischer Energie schreitet jedoch nicht so rasch voran. Die erweiterte Funktionalität der Geräte durch das sogenannte IoT wird daher Probleme in Bezug auf den hierdurch notwendigen Energieverbrauch mit sich bringen.

Bei Sensoren besteht zudem ein Interesse, die Situations- oder Objektumgebung der Sensoren bei der Auswertung der mit den Sensoren gezielt abgefragten, per Funk übertragenen Messgrößen zu erfragen. Beispielsweise ist es möglich, dass Sensoreinrichtungen an falschen Orten oder in falschen Gehäusen, als dies ursprünglich geplant war, installiert werden. Ferner möchte man bei Sensoren Kenntnis von bestimmten Gegebenheiten erhalten, wie z. B. über Manipulationen an fest installierten Sensoren (z.B. Verbrauchszählern) oder Abschirmungen von Sensoren. Beispielsweise können z.B. Metallteile oder dielektrische Materialien wie z. B. Kunststoffteile in der Umgebung einer Antenne des Sensors oder Aktors deren Impedanz beeinflussen, sodass eine flexible Impedanzanpassung erwünscht ist. Zudem können temporäre Störer dazu führen, dass Pakete zwar noch empfangen werden können, aber eine verminderte Empfangsleistung liefern. In diesem Rahmen ist es wünschenswert, eine zusätzliche Sensorik an den betreffenden Sensoren oder Aktoren einzusetzen. Diese benötigt jedoch wiederum zusätzliche Sensoren und/oder Prozessoren, die den Energieverbrauch zusätzlich belasten.

Druckschriftlicher Stand der Technik

Ein Verfahren gemäß dem Oberbegriff des Anspruchs 1 ist aus der DE 10 2016 010 045 A1 bekannt. Hierbei handelt es sich um ein Verfahren zum Verbessern der Antennenanpassung bei einem Smart-Meter-Zähler im Sendebetrieb. Die Antennenanpassung kann durch Umschalten eines unterschiedlich bemessenen Anpassnetzwerks erfolgen, welches Induktivitäten und/oder Kapazitäten umfasst. Jeder Smart-Meter-Zähler eines Netzwerks sendet eine Mehrzahl von Testpaketen mit jeweils entsprechend unterschiedlichen Anpassungen an einen Datensammler. Der Datensammler wertet die Testpakete aller Smart-Meter-Zähler hinsichtlich deren Empfangsfeldstärke aus, wählt dasjenige Testpaket mit der höchsten Empfangsfeldstärke aus und meldet die Auswahl zurück an den jeweiligen Smart-Meter-Zähler. Dieser sendet fortan mit der entsprechenden Antennenanpassung. Nachteilig bei diesem Verfahren ist es, dass für das Aussenden der Funksignale ein beträchtliches Maß an elektrischer Energie verbraucht und zudem der Funkkanal sehr stark belegt wird und deshalb unter Umständen sogar für einige Zeit blockiert sein kann.

Aufgabe der vorliegenden Erfindung

Die Aufgabe der vorliegenden Erfindung besteht darin, das gattungsgemäße Verfahren hinsichtlich Energieverbrauch und sowie Funkkanalbelegung zu verbessern.

Lösung der Aufgabe

Die Aufgabe wird durch ein Verfahren mit den Merkmalen nach Patentanspruch 1 gelöst. Zweckmäßige Ausgestaltungen des erfindungsgemäßen Verfahrens sind in den weiteren Ansprüchen beansprucht.

Erfindungsgemäß erfolgt eine Auswahl einer bestimmten Impedanzanpassung der Antenne in Abhängigkeit des Rauschens, welches jeweils für unterschiedliche Anpassungen der Impedanz der Antenne (Transformationswege) im Empfangspfad des Funkmoduls gemessen wird. Die Impedanz, die am Eingangsverstärker oder am LNA des Funkchips vorliegt, ergibt sich aus der unbekannten Antennenimpedanz sowie der jeweiligen Anpassung im Empfangspfad (Transformationsweg). Erfindungsgemäß wird bei den jeweiligen einstellbaren Anpassungen jeweils die Rauschleistung im Empfangspfad gemessen und die gemessenen oder daraus abgeleiteten Werte miteinander verglichen. Eine Anpassung, vorzugweise diejenige mit dem geringsten Rauschen, wird ausgewählt. Hierdurch kann die unbekannte, von den Umgebungsbedingungen beeinflusste Impedanz der Antenne im Empfänger (im Feld) bestimmt werden. Somit wird kein vorheriges Senden von Testpaketen wie bei dem Verfahren gemäß der DE 10 2016 010 045 A1 benötigt. Deshalb wird erheblich weniger Energie verbraucht. Als Folge davon kann die Betriebsdauer bei einem z. B. mit einer Batterie energieautark betriebenen Knoten ganz erheblich verlängert werden. Zudem wird aufgrund des Empfangsbetriebs zur Antennenanpassung eine erhebliche Entlastung des Funkkanals erreicht.

Die in Abhängigkeit des Rauschens entsprechend angepasste Impedanz kann für den Sendebetrieb verwendet werden, wodurch die Qualität der Datenübertragung vom betreffenden Knoten zu dem Empfänger der Sendung verbessert werden.

Als Folge davon kann vorgesehen sein, dass

(a) die Rauschzahl im Empfangspfad reduziert oder minimiert wird und/oder
(b) die Sendeleistung im Sendefall erhöht oder maximiert wird und/oder
(c) eine Umgebungsdetektion in Bezug auf den Empfang beeinflussender Gegebenheiten erfolgt.

Vorzugsweise erfolgt eine Einstellung der Anpassungen der Antenne entweder

(a) anhand eines Vergleichs der gemessenen Rauschleistungswerte oder daraus abgeleiteter Werte oder
(b) auf Basis eines Best-Fit-Verfahrens, bei dem eine Bewertung der gemessenen Rauschleistungswerte oder daraus abgeleiteter Werte unter Einbeziehung empirischer oder vorbestimmter Werte, die als Bezug für die Bewertung dienen, vorgenommen wird. Im Fall (a) liegen somit Umstände vor, bei denen alleine anhand des Vergleichs der gemessenen Rauschleistungswerte oder daraus abgeleiteter Werte die Antennenanpassung optimiert oder verbessert werden kann. Dies kann insbesondere dann der Fall sein, wenn die Rauschleistung am Eingang des Eingangsverstärkers oder LNA gleichbleibt und eine Variation des Gain (Verstärkungsfaktors) des Eingangsverstärkers oder LNA während der Anpassungen bzw. Optimierung nicht erfolgt oder vernachlässigbar ist. Ist letzteres nicht gegeben, beispielsweise, weil sich während der Anpassungen bzw. Optimierung die Temperatur und/oder die Bandbreite und/oder der Gain des Eingangsverstärkers oder LNA ändert bzw. ändern, kann eine Optimierung auf Basis des Falls (b) durchgeführt werden.

Im Fall (b) werden die am Knoten gemessenen Rauschleistungswerte mit vorher für eine Mehrzahl von Antennenimpedanz-Werten empirisch ermittelten und im Knoten, z. B. in Tabellenform, gespeicherten Rauschleistungswerten verglichen. Die Schätzung der unbekannten Antennenimpedanz geschieht dadurch, dass aus dem Vergleich diejenige Antennenimpedanz als Ergebnis der Schätzung gewählt wird, deren zugehörigen gemessenen Rauschleistungswerte zu den vorher empirisch ermittelten und gespeicherten Rauschleistungswerten am nächsten liegen. Insbesondere kann dies durch eine Minimierung der euklidischen Distanz zwischen den gemessenen und gespeicherten Rauschleistungswerten erreicht werden.

Im Rahmen des Best-Fit-Verfahrens können auch im Knoten gemessene von der Impedanz der Antenne abhängige Parameter (z. B. Gain oder Rauschzahl) mit vorher für eine Vielzahl von vorgegebenen Antennenimpedanz-Werten empirisch ermittelten und, vorzugsweise im Knoten, gespeicherten entsprechenden Parametern verglichen werden.

Beispielsweise kann die Anpassung der Impedanz der Antenne auf Basis eines Vergleichs der durch die unterschiedlichen Anpassungen begründeten Rauschzahlen des Empfangspfads des Funkmoduls im Empfangsfall erfolgen. Um herauszufinden, welche Anpassung am besten ist, werden die jeweiligen Rauschzahlen ermittelt und miteinander verglichen. Für jede Anpassung wird somit im Empfangsfall jeweils eine Rauschzahl ermittelt.

Demgemäß kann vorgesehen sein, dass sukzessive mehrere unterschiedliche Anpassungen bzw. Anpassnetzwerke im Empfangspfad eingestellt werden, zu denen jeweils das zugehörige Rauschen (Rauschpegel) bzw. die zugehörige Rauschzahl ermittelt wird und eine Anpassung davon anhand eines von einer ermittelten Rauschzahl abhängigen Kriteriums für den Sende- und/oder Empfangsbetrieb ausgewählt wird.

Ein solches Kriterium kann beispielsweise darin bestehen, dass diejenige Anpassung ausgewählt wird, zu der das gemessene Rauschen bzw. die ermittelte Rauschzahl am niedrigsten ist.

Vorzugsweise kann ein vorher bekannter Verstärkungsfaktor (Gain), z. B. ein maximaler Gain, in dem Empfänger (Front End bzw. LNA) vorher eingestellt werden. Hierdurch kann die Leistung vor dem Empfänger einer weiter hinten im Empfangszweig gemessenen Rauschleistung zugeordnet werden. Zum Beispiel kann die Rauschleistung im Digitalteil nach einem Analog-Digital-Umsetzer gemessen werden. Bei Bedarf kann der Verstärkungsfaktor auch im Zuge des Verfahrens variiert werden.

Da das Rauschen temperaturabhängig ist, kann es vorteilhaft sein, wenn bei der Ermittlung der Rauschzahl die Temperatur-bedingte Rauschleistung mit einbezogen wird. Hierzu wird bzw. werden beispielsweise die Umgebungstemperatur an der der Sensor- oder Aktoreinrichtung und/oder die Temperatur der Sensor- oder Aktoreinrichtung erfasst und bei der Ermittlung der Rauschzahl bzw. des Rauschens mit einbezogen.

Die Ermittlung der Rauschzahl sollte vorzugsweise innerhalb einer ausgewählten Auflösungsbandbreite des Rauschens erfolgen. Demgemäß kann mittels mehrerer Filter ein Teil eines Gesamtspektrums ausgeschnitten und z. B. digital bereitgestellt werden. Die Auflösungsbandbreite bestimmt die Rauschleistung, welche sich im Empfänger dem Nutzsignal additiv überlagert.

Die Empfangsschaltung umfasst zur Einstellung eines unterschiedlichen Verstärkungsfaktors (Gain) mindestens einen Eingangsverstärker, vorzugsweise einen sogenannten LNA (Low Noise Verstärker). Alternativ oder zusätzlich kann zur Einstellung des Verstärkungsfaktors auch ein RF Front End Verstärker verwendet werden. Vorteilhaft können daher ohnehin schon in einem Empfangspfad üblicherweise vorhandene Funktionsteile zur erfindungsgemäßen Impedanzanpassung der Antenne verwendet werden.

Zweckmäßigerweise erfolgt die Messung der Rauschleistung im Empfangspfad nach oder am Ausgang eines Eingangsverstärkers oder LNAs.

Zur Umsetzung des Best-Fit-Verfahrens können eine erste Rauschzahl sowie eine zweite, von der ersten Rauschzahl unterschiedliche zweite Rauschzahl (z. B. minimale Rauschzahl, maximale Rauschzahl) und/oder ein erster Verstärkungsfaktor sowie ein vom ersten Verstärkungsfaktor unterschiedlicher zweiter Verstärkungsfaktor (z. b. minimaler Verstärkungsfaktor sowie maximaler Verstärkungsfaktor) als vorbekannte Referenzwerte eines Rauschzahlbereichs bzw. Verstärkungsfaktorbereichs abgespeichert werden. Diese Referenzwerte können vorab empirisch festgestellt werden. Die Referenzwerte erlauben eine Berechnung des jeweiligen Abstandes zum optimalen Punkt der Rauschzahl bzw. des Verstärkungsfaktors.

Vorzugsweise wird das Verfahren so betrieben, dass die Änderung des Verstärkungsfaktors kleiner ist als die Änderung der Rauschzahl.

Das Best-Fit-Verfahren kann in einer weiteren Ausgestaltung folgende Schritte umfassen:

(a) die Rauschzahl sowie der Verstärkungsfaktor werden für eine Mehrzahl von Impedanzen des Empfangspfads empirisch ermittelt und für einen späteren Abruf gespeichert,

(b) eine Mehrzahl von vorher festgelegten, auswählbaren Trans-formationswegen (Anpassungen bzw. Anpassnetzwerke) werden durchlaufen, bei denen jeweils eine Veränderung der Impedanz des Empfangspfads erfolgt,

(c) aus den aus (a) und (b) vorliegenden Daten wird jeweils eine zugehörige Modell-Rauschzahl und/oder ein zugehöriger Modell-Verstärkungsfaktor berechnet und daraus ein Modell-Grundrauschen berechnet,

(d) während des Betriebs des Knotens wird für die Transformationswege das Grundrauschen gemessen (gemessener Rauschfloor) und

(e) es wird eine Impedanz der Antenne durch eine Näherungsverfahren auf Basis einer Abweichung von gemessenem Rauschfloor zu dem Modell-Grundrauschen ermittelt.

Die Ermittlung der Rauschzahl sowie des Verstärkungsfaktors für die Mehrzahl von Impedanzen des Empfangspfads sowie das Näherungsverfahren zur Ermittlung (Abschätzung) der unbekannten Impedanz der Antenne erfolgt hierbei vorzugsweise auf Basis des Smith Diagramms. Dieses vereinfacht es, eine sinnvolle bzw. ausgewogene Wahl der zu bestimmenden Antennenimpedanzen und Transformationswege zu treffen. Die Lage von Impedanzpunkte der Antenne wird im Smith-Diagramm auf empirischer Basis geschätzt. Die Lagepunkte der Impedanz ergeben sich durch unterschiedliche Faktoren der Installation der Antenne. Unterschiedliche Anpassungen (Anpassnetzwerke) führen zu einer Verschiebung der Lagepunkte der Impedanz in dem Smith-Diagramm. Man kann mit dem Smith-Diagramm feststellen, um wie viel sich der Verstärkungsfaktor sowie die Rauschzahl bei einer bestimmten Impedanz ändern.

Vorzugsweise wird das Best-Fit-Verfahren als Grid-Suche über eine bestimmte Anzahl an ermittelten unterschiedlichen Antennenimpedanzen durchgeführt.

Gemäß einer weiteren vorteilhaften Ausgestaltung kann eine Messung der Rauschleistung an digitalen Daten, insbesondere auf einem Mikrokontroller, erfolgen. Hierzu können die von dem Knoten empfangenen Daten im Empfänger sogleich in I/Q-Daten gewandelt werden. Die jeweilige Rauschzahl zu unterschiedlichen Impedanzen kann dann anhand der I/Q-Daten unterschiedlicher Rauschfloors auf einer SDR (Software Defined Radio) Basis ermittelt werden. Eine Verbesserung der Anpassung der Antenne kann hierdurch deutlich schneller erfolgen.

Die empirischen Impedanzen können als I/Q-Daten auf einem Mikrochip gespeichert sein. Die Impedanz der Antenne kann auf Basis eines Vergleichs der gespeicherter I/Q-Daten mit den gemessenen I/Q-Daten ermittelt werden.

Digitale Daten bzw. I/Q-Daten können für die Messung der Rauschleistung aus dem Hauptdatenstrom abgezweigt werden und/oder Samples der digitalen Daten bzw. I/Q-Daten durch Dezimierung auswählt und diese nur für die Messung der Rauschleistung verwendet werden.

Insbesondere kann eine Messung der jeweiligen Rauschleistung bei den jeweiligen einstellbaren Anpassungen der Antenne (Transformationswege) an einem Datenpaket vorgenommen werden.

Das erfindungsgemäße Verfahren eignet sich bevorzugt für Schmalbandsysteme, d. h. insbesondere für Bandsysteme mit einer Nutzsignalbandbreite von kleiner 100 kHz, vorzugsweise kleiner 80 kHz, besonders vorzugsweise kleiner 50 kHz.

Die langzeitautarke Energieversorgungseinrichtung, insbesondere Batterie, des Knotens kann insbesondere eine Kapazität von weniger als 20 Ah, häufig sogar kleiner als 3 Ah aufweisen. Aus diesem Grund ist der Energieeinspareffekt des erfindungsgemäßen Verfahrens im Vergleich zu den bekannten Verfahren zur Verbesserung der Antennenanpassung besonders wichtig.

In vorteilhafter Weise kann das erfindungsgemäße Verfahren auch zur laufenden Störer Erfassung und/oder Störer Überwachung eingesetzt werden. So können beispielsweise Messungen während z. B. einer temporären Einwirkung eines Störers auf die Antenne der Sensoreinrichtung abhängig von der ermittelten Impedanz der Antenne identifiziert und/oder ausgesondert werden. Hierdurch kann wiederum die Messgenauigkeit erhöht werden.

Sofern am funkkommunikationsfähigen Knoten, vorzugsweise über eine lösbare Verbindung, austauschbare Antennen verwendet werden, kann mithilfe des Verfahrens eine Anpassung der Impedanz in Abhängigkeit der ausgewählten Antennen anhand der Messung der Rauschleistung vorgenommen werden.

Vorzugsweise weisen der Sende- und Empfangspfad einen identischen Anpasswiderstand auf. Die adaptive Anpassung ist damit für das Empfangen sowie das Senden gleich.

Ferner umfasst die vorliegende Erfindung einen funkkommunikationsfähigen Knoten, der gemäß dem erfindungsgemäßen Verfahren betrieben wird.

Beschreibung der Erfindung anhand von Ausführungsbeispielen

Nachfolgend wird die Erfindung anhand von bevorzugten Ausführungsbeispielen unter Bezug auf die Zeichnungen näher erläutert. Es zeigen:

Fig. 1     eine stark vereinfachte schematische Darstellung einer Anordnung mehrerer bidirektional funkkommunikationsfähiger Knoten in einem Kommunikationsnetzwerk,

Fig. 2     eine stark vereinfachte schematische Darstellung eines Beispiels eines Knotens in Form einer Sensoreinrichtung des Kommunikationsnetzwerks von Fig. 1,

Fig. 3     eine stark vereinfachte schematische Darstellung eines ersten Beispiels eines Sende- sowie Empfangspfads des Knotens des Kommunikationsnetzwerks von Fig. 1;

Fig. 4     eine stark vereinfachte schematische Darstellung eines zweiten Beispiels eines Empfangspfads des Knotens des Kommunikationsnetzwerks von Fig. 1;

Fig. 5     eine beispielhafte Darstellung der aufaddierten Rauschleistung R des Empfängers des Knotens bei einer Auflösungsbandbreite von 20kHz und einer Temperatur von 20°C;

Fig. 6     eine Darstellung der Abhängigkeit der Rauschleistung/Hz von der Temperatur in Grad Celsius;

Fig. 7    eine stark vereinfachte schematische Darstellung der Zusammenhänge in einem Smith-Diagramm sowie

Fig. 8    eine stark vereinfachte schematische Darstellung einer Funkchips mit Schnittstelle zur Zurverfügungstellung von I/Q Daten zur Rauschzahlermittlung.

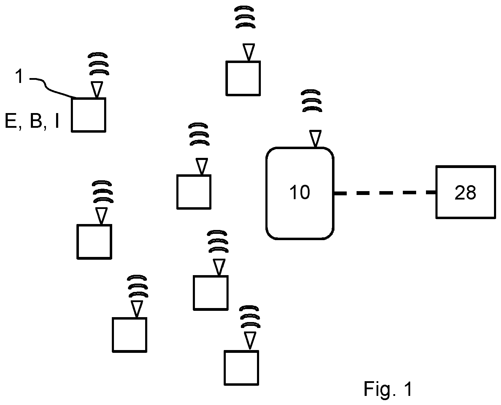

Fig. 1 zeigt eine Anordnung mehrerer bidirektional funkkommunikationsfähiger Knoten 1, z. B. in Form von Sensoreinrichtungen. Diese senden Sensordaten z. B. Verbrauchsdaten und/oder sonstige Betriebsdaten an einen Datensammler 10, in dem die Daten aufbereitet und z. B. über das Internet zur weiteren Verwendung an eine Datenzentrale 28 weitergeleitet werden.

Eine Sensoreinrichtung kann z. B. eine physikalische oder chemische Eigenschaft E messen, beispielsweise die Temperatur eines Objekts, den Durchfluss eines Fluids oder Gases als Bestandteil eines Durchflusszählers oder die elektrische Leitzahl (um beispielsweise einen Salzgehalt zu messen). Eine Sensoreinrichtung kann alternativ z.B. die stoffliche Beschaffenheit B oder beispielsweise eine Wasserqualität anhand der Reaktion mit Reagenzien ermitteln. Ein Farbumschlag zeigt, ob die Qualität des Wassers ausreichend gut ist. Schließlich kann eine Sensoreinrichtung auch Messgrößen bezüglich einer situativen Information I erzeugen. Derartige Sensoreinrichtungen können generell bei der Umsetzung des "Internet of Things" (IoT) eingesetzt werden.

Der Knoten 1 könnte bei Bedarf auch als Aktoreinrichtung ausgebildet sein. Ein Aktor erhält elektrische Signale und wirkt auf ein äußeres Objekt ein. Neben dem klassischen Fall einer mechanischen Einwirkung (etwa über ein Stößel, den der Aktor betätigt) gibt es die Möglichkeit einer elektromagnetischen Einwirkung (wenn der Aktor ein elektrisches oder magnetisches Feld erzeugt, das einen ferromagnetischen Gegenstand in einer bestimmten Position hält). Schließlich kann der Aktor auch eine sekundäre Reaktion in dem Objekt über Steuersignale hervorrufen und gewissermaßen als Übersetzer von Signalen, die er selbst über Funk empfängt, in elektrische Signale dienen, die er über eine Leitung weitergibt.

Schließlich könnte ein Knoten 1 sowohl Eigenschaften einer Sensoreinrichtung der oben beschriebenen Art als auch zugleich einer Aktoreinrichtung der oben beschriebenen Art ins sich vereinen.

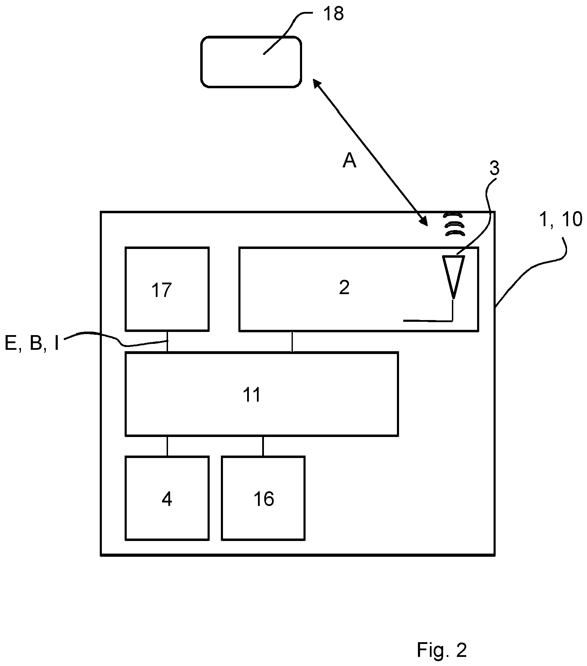

Anhand der Fig. 2 wird ein beispielhafter Aufbau eines Knotens 1 in Form einer Sensoreinrichtung näher erläutert, die aber prinzipiell auch bei einer Aktoreinrichtung identisch oder ähnlich gegeben sein kann.

Die Sensoreinrichtung umfasst eine langzeitenergieautarke Energieversorgungseinrichtung 4, insbesondere eine Batterie. Diese ist insbesondere so ausgelegt, dass sie die Sensoreinrichtung über Jahre hinweg mit elektrischer Energie versorgt. Vorzugsweise weist die Energieversorgungseinrichtung im Hinblick auf eine energiesparende Betriebsweise eine Kapazität von nicht mehr als 20 Ah auf.

Ferner ist ein Funkmodul 2 vorgesehen, in das eine Antenne 3 integriert ist. Aufgrund des beschränkten Bauraums ist die Antenne 3 zwangsläufig schmalbandig. Darüber hinaus umfasst der Knoten 1 einen Mikroprozessor 11, welcher als Teil des Funkmoduls 2 oder auch separat davon vorgesehen sein kann. Der Mikroprozessor 11 umfasst einen Speicher 16. Ferner kann der Knoten 1 mindestens ein Sensorelement 17, z.B. ein Temperaturfühler, piezoelektrischer Wandler oder dergleichen umfassen, welches dazu dient, eine physikalische oder chemische Eigenschaft E, eine stoffliche Beschaffenheit B oder eine situative Information I zu erfassen und eine entsprechende Messgröße E, B, I auszugeben.

Alternativ kann das Funkmodul 2 auch eine in der Zeichnung nicht dargestellte koppelbare externe Antenne aufweisen. Auf diese Weise können über eine lösbare Verbindung an dem Knoten 1 bzw. am Funkmodul 2 verschiedene Antennentypen verwendet werden. Hierbei eignet sich das vorliegende Verfahren, für jeden Antennentyp die geeignete Anpassung zu finden.

Des Weiteren ist in Fig. 2 beispielhaft ein Objekt 18 in der Nähe der Antenne 3 des Funkmoduls 2 in einem Abstand A zum Knoten 1 bzw. zu dessen Antenne 3 dargestellt. Bei einem solchen Objekt 18 kann es sich beispielsweise um einen temporären Störer oder aber um einen permanent vorhandenen Störer handeln.

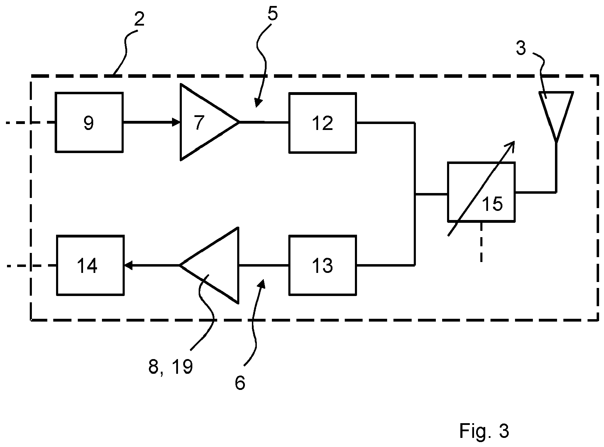

Fig. 3 zeigt in stark vereinfachter schematischer Darstellungsweise eine beispielhafte Variante des Sende- 5 sowie Empfangspfads 6 des Funkmoduls 2 des aus Fig. 2 ersichtlichen Knotens 1. Der Sendepfad 5 umfasst ein TX-Modulationsglied 9 zur Modulation der z. B. von dem in Fig. 3 nicht dargestellten Sensor stammenden Signale, einen PA bzw. Leistungsverstärker 7 sowie ein Anpassglied 12, welches z. B. eine Anpassung auf 50 Ohm bewirkt. Der Empfangspfad 6 umfasst ebenfalls ein entsprechendes Anpassglied 13, z.B. ebenfalls mit 50 Ohm Anpassung, sowie einen Verstärker, z.B. einen LNA 8 ("Low Noise Amplifier") und/oder einen RF Front-End 19, zur Verstärkung der über die Antenne 3 empfangenen Signale.

Der Empfangspfad 6 umfasst des Weiteren ein Rauschzahl-Schätzglied 14, dessen Funktionsweise im Nachgang näher erläutert wird. Der Antenne 3 nachgeordnet ist ein Impedanz-Anpassglied 15 mit mehreren Anpassungen oder Anpassnetzwerken zur wahlweise mehrstufigen Impedanzanpassung des Eingangspfads 6, welches eine Mehrzahl von wahlweise schaltbaren Impedanzen umfasst, wie dies beispielsweise in der DE 10 2016 010 045 A1 beschrieben ist. Alternativ können zu diesem Zweck auch andere steuerbare, die Impedanz anpassende Elemente wie z. B. durch Spannung sich ändernde Kapazitäten (z. B. Kapazitätsdioden) hierbei zum Einsatz kommen. Die Ansteuerung des Impedanz-Anpassglieds 15 kann vorzugsweise durch den Mikroprozessor 11 erfolgen. Das Impedanz-Anpassglied 15 kann beispielsweise auch über feste Anpassnetzwerke auf einer Leiterplatte realisiert sein.

Gemäß der Erfindung wird mittels des Impedanz-Anpassglieds 15 die Impedanz des Empfangspfads 6 und damit das Rauschen sukzessive verändert und hierzu jeweils die zugehörige Rauschleistung (Rauschpegel) im Empfangspfad 6 gemessen. Die Messung der Rauschleistung erfolgt vorzugsweise am Ausgang des Verstärkers bzw. LNA 8. In dem Auswertemodul 14 wird diejenige Impedanzanpassung ausgewählt, bei der die niedrigste Rauschleistung gemessen wird bzw. bei der die Rauschzahl am niedrigsten ist.. Die Impedanzanpassung kann dann für den Empfangs- und/oder Sendebetrieb verwendet werden.

In einem vereinfachten Fall wird davon ausgegangen, dass sich bei der mehrstufigen Impedanzanpassung des Eingangspfads 6 der Verstärkungsfaktor G des Verstärkers bzw. LNA 8 nicht oder zumindest nicht wesentlich verändert. Die Rauschzahl hängt hierbei nur von einer Variation der Rauschleistung am Ausgang des Verstärkers bzw. LNA 8 ab.

Ist das Funkmodul 2 im Empfangsmodus, so wird die für die Rauschanpassung des Empfängers günstige vorzugsweise optimale Anpassung bzw. das für die Rauschanpassung des Empfängers günstige vorzugsweise optimale Anpassnetzwerk eingestellt. Daraus resultiert eine Minimierung der Rauschzahl.

Ist das Funkmodul 2 im Sendemodus, so wird die für die Leistungsanpassung beim Senden günstige vorzugsweise optimale Anpassung bzw. das günstige vorzugsweise optimale Anpassnetzwerk eingestellt. Daraus resultiert eine Maximierung der Sendeleistung.

Über das Rauschzahl-Schätzverfahren kann somit zunächst die unbekannte Antennenimpedanz bestimmt werden. Aus vorher empirischen Ermittlung kann im Funkmodul für eine jede Antennenimpedanz die optimal zu wählende Einstellung des Anpassglieds gespeichert werden. Wird also durch das Rauschzahl-Schätzverfahren die Antennenimpedanz bestimmt, kann im Sendefall die Einstellung des Anpassnetzwerks verwendet werden, welche im Sinne der Leistungs-anpassung die über die Antenne abgestrahlte Sendeleistung maximiert.

Die adaptive Anpassung der Impedanz ist bei der in Fig. 3 gezeigten Konfiguration gleich. Die Empfangsanpassung oder Rauschanpassung betrifft somit hierbei gleichzeitig auch den Sendepfad 5.

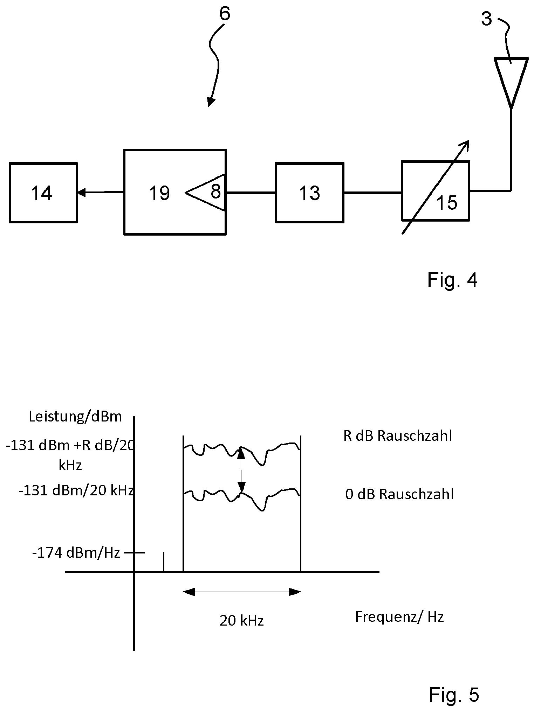

Bei der in Fig. 4 gezeigten Konfiguration des Empfangspfads 6 ist das Impedanz-Anpassglieds 15 Bestandteil des Empfangspfads 6.

Für die Rauschzahl F gilt Folgendes

$$F = \frac{\mathrm{Nout}}{(\mathrm{G\_LNA} * \mathrm{Nin})}$$

wobei:

F die Rauschzahl
Nout der Rauschpegel am Ausgang des LNAs
G_LNA die Verstärkung des LNAs
Nin der Rauschpegel am Eingang des LNAs ist

Im Feld kann weder G_LNA, noch Nin gemessen werden. Folglich kann die Rauschzahl nicht gemessen werden. Deswegen muss sich die Rauschzahl-Optimierung auf die Messung des Ausgangsrauschpegels Nout stützen. Für Nout gilt Folgendes:

$$\mathrm{Nout} = \mathrm{G\_LNA} * \mathrm{Nin} + \mathrm{N\_LNA}$$

wobei N_LNA der Rauschbeitrag des LNAs ist.

Eine Variation von Nout kann also von einer Variation von G_LNA und/oder von N_NLA stammen. Es wird angenommen, dass Nin während der Optimierung gleichbleibt (die Temperatur und die Bandbreite bleiben konstant während der Optimierung).

Es können also zwei Fälle unterschieden werden:

1. Die Variation von G_LNA ist im Vergleich zu der Variation von Nout über die Eingangsimpedanz des LNAs vernachlässigbar

2. Die Variation von G_LNA ist im Vergleich zu der Variation von Nout über die Eingangsimpedanz des LNAs nicht vernachlässigbar

Daraus resultieren zwei Fallgestaltungen:

1. Fall:
Die Variation der Rauschzahl stammt nur von der Variation von Nout. Dadurch kann eine Optimierung der Rauschzahl über eine direkte Messung des Rauschpegels am Ausgang erfolgen. Es wird dasjenige Matching gewählt, das den niedrigsten Nout ergibt.

2. Fall:
Nout ist gleichzeitig von N_LNA und G_LNA abhängig, die bei einer Änderung der Eingangsimpedanz des LNAs Zin unabhängig variieren können. Daher ist eine einfache Optimierung der Rauschzahl über eine Minimierung von Nout nicht möglich. Daher wird folgendes Verfahren verwendet:

Die unbekannte Antennenimpedanz Z_Ant ist konstant über die Messungen. Nout wird über mehrere Transformationswege (Anpassungen Z0, Z1, Z des Anpassungsnetzwerks) bei konstanter Z_Ant bestimmt. Alle diesen Messungen werden zusammen in einem Best-Fit-Verfahren bewertet. Die Charakterisierung des LNAs bezüglich der Abhängigkeit von Nout von der Eingangsimpedanz des LNAs wird vorherbestimmt. Sie dient als Vorlage zum Best-Fit-Verfahren über alle Transformationswege, um auf die Impedanz der Antenne rückzuschließen.

Durch die unterschiedlichen Anpassungen Z0, Z1, Zn (Transformationswege) "sieht" der Empfänger am Ausgang des RF Front Ends 19 bzw. des LNAs 8 somit jeweils unterschiedliche Impedanzen, die aus der unbekannten Impedanz Z_Ant der Antenne und der jeweiligen Anpassung resultieren. Hierdurch ändert sich wiederum die Rauschzahl F0, F1, Fn des Empfängers am Ausgang des RF Front Ends 19 und/oder des LNAs 8, die durch Messung der Rauschleistung am Ausgang des RF Front Ends 19 und/oder des LNAs 8 geschätzt und verglichen werden kann.

Ein Vergleich der Rauschzahlen kann vorzugsweise auf Basis von I/Q Daten digital vorgenommen werden.

Die Schätzung der Rauschzahl F0, F1, Fn erfolgt hierbei wie folgt: In dem RF Front End 19 wird der Verstärkungsfaktor (Gain) G0, G1, Gn auf einen bekannten Wert (z. B. maximaler Wert eingestellt, der in dem Speicher 16 des Mikroprozessors 11 abgespeichert sein kann. Der (optionale) LNA 8 wäre alternativ auch verstellbar und könnte ebenfalls mehrere bekannte Werte annehmen. Durch den bekannten Verstärkungsfaktor kann man die Leistung vor dem RF Front End 19 oder LNA 8 in dBm nach der Analog-Digital-Umsetzung einem Wert auf einer digitalen Skala in dBFS zuordnen.

In dem RF Front End 19 kann zudem ein Teil des gesamten Frequenzspektrums (z. B. 20 kHz) mittels mehrerer Filter ausgeschnitten und vorzugsweise digital bereitgestellt werden. Die Kette der digitalen Filter bewirkt eine Auflösungsbandbreite, die die Rauschleistung festlegt, welche am Eingang des Empfänger bzw. RF Front End 19 bzw. LNA 8 vorherrscht. Das Beispiel in Fig. 5 zeigt eine Auflösungsbandbreite von z. B. 20 kHz.

Ferner kann die Abhängigkeit der Rauschleistung von der Temperatur T in dem erfindungsgemäßen Verfahren berücksichtigt werden. Diese ist ermittelbar aus der Gleichung

$$\text{Rauschleistung} = kT\Delta f \qquad (1)$$

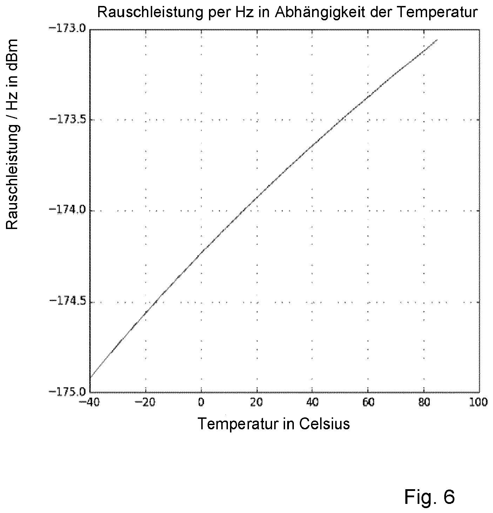

wobei T die Temperatur (K), k die Bolzmann-Konstante und Δf die Bandbreite ist. Der obige Zusammenhang ist in dem Diagramm gemäß Fig. 6 veranschaulicht.

Wenn man bei z.B. 20°C eine Rauschleistung von z.B. ca. -174 dBm/Hz und eine Bandbreite von z.B. 20 kHz hat, ergibt sich daraus eine Rauschleistung in dem gesamten Filter als -174 dBm/Hz +10log10(20kHz) in Höhe von -131 dBm. So hoch wäre gemäß Fig. 5 bei einer Auflösungsbandbreite von 20 kHz das Grundrauschen, wenn der Empfänger bzw. das RF Front End 19 bzw. der LNA 8 eine Rauschzahl von 0 dB hätte, es sich also um einen idealen Empfänger bzw. Verstärker handeln würde, der dem Eingangssignal keinen zusätzlichen Rauschbeitrag hinzufügen würde

Würde man somit beispielsweise am Ausgang des Empfänger bzw. des RF Front Ends 19 bzw. des LNA 8 eine Rauschleistung von -125 dBm messen, würde dies in dem Beispiel bedeuten, dass der Empfänger bzw. das RF Front End 19 bzw. der LNA 8 eine Rauschzahl von 6 dB aufweist, das gemessene Rauschen also durch den Eigenrauschbeitrag des RF Front Ends 19 bzw. des LNA 8 um einen entsprechenden Faktor höher ist als der Rauschpegel an dem betreffenden Eingang.

Die Rauschzahl F wird geschätzt, indem jeweils der erwartete Rauschgrund von der gemessenen gesamten Rauschleistung P_ges abgezogen wird.

Nachstehend wird ein konkretes Beispiel eines Best-Fit-Verfahrens zur Rauschzahlschätzung beschrieben. In einem "Best Fit Verfahren" werden empirische Größen mit gemessenen Größen oder daraus abgeleiteten Größen verglichen und anhand einer Best-Fit-Regel diejenigen Größen ausgewählt, die am günstigsten sind also "am besten passen". Dies ist dann besonders vorteilhaft, wenn die bei den unterschiedlichen Anpassungen jeweils gemessenen Rauschleistungen von zusätzlichen Einflüssen abhängig sind wie z. B. von der Veränderung des Rauschpegels am Eingang des Verstärkers bzw. LNAs 8 und/oder von Temperaturschwankungen und/oder von Bandbreiten-abhängigen Rauschleistungsanteilen.

In dem Speicher 16 des Mikroprozessors 11 können hierzu vorzugsweise eine minimale sowie maximale Rauschzahl abgespeichert, so dass z. B. zwei Referenzwerte für jede Rauschzahl-Schätzung vorliegen. Daraus kann geschlossen werden, wie weit die aktuelle Schätzung der Rauschzahl vom optimalen Punkt entfernt ist. In dem Speicher 16 des Mikroprozessors 11 kann vorzugsweise auch ein minimaler sowie maximaler Verstärkungsfaktor (Gain) abgespeichert sein.

Zusätzlich zur Anpassung der Impedanz kann auch der Verstärkungsfaktor (Gain) z. b. stufenweise verändert werden (G0, G1, Gn) .

Bei der Rauschzahlschätzung sind der im RF Front End 19 oder LNA 8 eingestellte Verstärkungsfaktor G0, G1, Gn und/oder eine automatische Verstärkungsregelung (AGC) mit zu berücksichtigen.

Die Änderung des Verstärkungsfaktors G ist vorzugsweise kleiner, insbesondere um einen Faktor von mindestens 3 kleiner, als die Änderung der Rauschzahl.

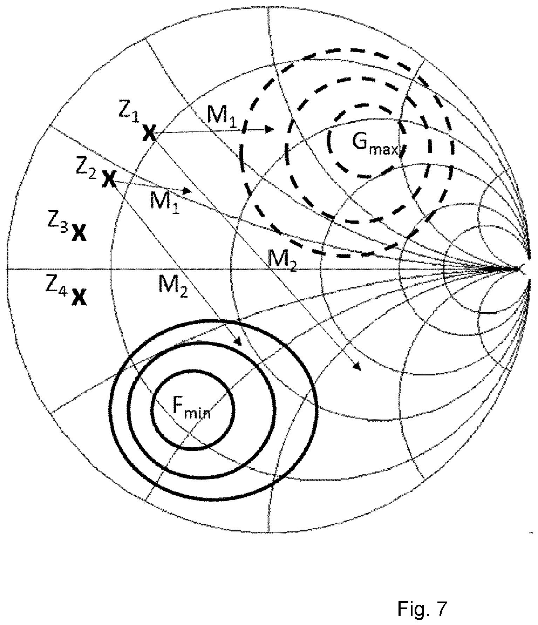

Nachstehend wird anhand der Fig. 7 ein weiteres Beispiel anhand eines Best-Fit-Verfahrens erläutert.

Fig. 7 zeigt in stark vereinfachter schematischer Darstellung ein sogenanntes Smith-Diagramm. Hierbei handelt es sich um ein kreisförmiges Diagramm, welches ein komplexes Koordinatensystem zeigt, in dem Impedanzen auf eine geometrische Konstruktion zurückgeführt sind. In dem Smith-Diagramm gemäß Fig. 7 sind beispielsweise vier unterschiedliche Impedanzpunkte Z1-Z4 eingetragen, die die Impedanzen der Antenne 3 eines Knotens 1 bei unterschiedlichen Installationen des Knotens definieren. Die Impedanzpunkte Z1-Z4 auf dem Diagramm sind vorbekannt und können durch vorhergehende Messungen bei unterschiedlichen Installationssimulationen des Knotens 1 ermittelt werden. Hierdurch ist eine Startmenge von Impedanz-Positionen innerhalb des Smith-Diagramms gemäß Fig. 7 festgelegt.

Ebenfalls festgelegt sind eine Mehrzahl von Transformationswegen für verschiedene Einstellungen eines adaptiven Matching-Netzwerks der Impedanz, die in dem Smith-Diagramm gemäß Fig. 7 als Pfeilvektoren M1-M2 von jedem Impedanzpunkt Z1-Z4 verlaufen. In Fig. 7 sind der Übersichtlichkeit halber die Transformationswege M1 und M2 zu den Punkten Z3 und Z4 nicht dargestellt. Ebenfalls der Übersichtlichkeit halber sind die Transformationswege jeweils stark vereinfacht dargestellt, und zwar dahingehend, dass nur der Start- und der Zielpunkt der Transformation schematisch eingezeichnet sind. Der genaue Verlauf des Transformationswegs vom Start- zum Zielpunkt folgt einem komplexeren Pfad im Smith Diagramm, der sich aus der Topologie und Ausführung ggf. mehrstufigen Zusammenschaltung von Induktivitäten und Kapazitäten ergibt.

Man kann ebenfalls empirisch bestimmen, um wieviel sich der Verstärkungsfaktor (Gain) und die Rauschzahl (F) in Abhängigkeit der Impedanz ändert. Dies bedeutet, dass die um Fmin sowie Gmax verlaufenden geschlossenen Linien empirisch bestimmt werden können. Die geschlossenen Linien bzw. Kreise bei G entsprechen solchen mit konstanter Verstärkung (Gain) des Empfängers (RF Front-End 19, LNA 8). Im Bereich des kleinsten Kreises ist die Verstärkung am stärksten (Gmax). Die Kreise bzw. geschlossenen Linien um F entsprechen solchen mit einer konstanten Rauschzahl. Im Bereich des kleinsten Kreises ist die Rauschzahl F am niedrigsten (Fmin). Die betreffenden geschlossenen Linien bzw. Kreise sind abhängig von dem Empfänger (RF Front-End 19, LNA 8) und im Labor vorher feststellbar und damit vorbekannt. Sie können in dem Speicher 16 des Mikrocomputers 11 (vgl. Fig. 2) des Knotens 1 abgespeichert werden.

Demzufolge kann man eine große Anzahl verteilter Impedanzen Z1-Zn vorher festlegen und in dem Speicher 16 des Mikroprozessors 11 des Knotens 1 ablegen. Die Rauschzahl F sowie Verstärkung G (Gain) sind somit deterministische Funktionen der Quellimpedanz des Empfängers (RF Front-End bzw. LNA).

Die Quellimpedanz des Empfängers Z_Q setzt sich wiederum zusammen aus einer unbekannten Antennenimpedanz Z_Ant und den durch das variable Antennen-Matching gegebenen Transformationsweg T_Match (festgelegt durch die Vektoren M1, M2, M3...). Die Schaltung kann N verschiedene, auswählbare und vorbekannte Transformationswege M aufweisen. Für die unbekannte Antennenimpedanz Z_Ant und einem aus den N möglichen Wegen gewählten Transformationsweg T_Match lässt sich aus den im Speicher 16 gespeicherten empirischen Daten folgendes modellmäßig berechnen:

$$\text{Rauschzahl Modell: } F\_Modell\ (Z\_Q) = F\_Modell\ (Z\_Ant,\ T\_Match) \qquad (2)$$

$$\text{Gain Modell: } G\_Modell(Z\_Q) = G\_Modell\ (Z\_Ant,\ T\_Match) \qquad (3)$$

Nun wird für alle N möglichen Transformationswege das Grundrauschen gemessen, wodurch man einen Vektor Grundrauschen_gemessen mit N Elementen erhält. Für diese N Transformationswege lässt sich aus den obigen Modelldaten ein von der unbekannten Antennenimpedanz Z_Ant abhängiges zu erwartendes Grundrauschen berechnen:

$$Grundrauschen\_Modell(Z\_Ant, \ T\_Match) \ = \ -174 \ + \ +10log10(20kHz) \ +$$

$$F\_Modell \ (Z\_Ant, \ T\_Match) + G\_Modell \ (Z\_Ant, \ T\_Match) \qquad (4)$$

Damit kann mathematisch über eine Minimierung der Abweichung zwischen dem gemessenen und dem Modellgrundrauschen die unbekannte und gesuchte Antennenimpedanz bestimmt werden:

$$Z\_Ant\_gesucht = Z\_Ant\_min \ Abstand \ Modell \ zu \ Messung \qquad (5)$$

$$Z\_Ant\_gesucht = (Z\_Ant\_min) \ || \ Grundrauschen\_gemessen \ (T\_Match) \ -$$

$$Grundrauschen\_Modell \ (Z\_Ant, \ T\_Match) \ || \qquad (6)$$

Die Minimierung der obigen kontinuierlichen Gleichung kann im Mikroprozessor des Knotens 1 vorzugsweise als Grid-Suche über eine bestimmte Anzahl an in Frage kommenden Antennenimpedanzen K durchgeführt werden.

Beispielsweise erhält man bei vier Transformationswegen und zwanzig in Frage kommenden Antennenimpedanzen einen Vektor Grundrauschen_gemessen mit vier Einträgen und zwanzig Vektoren Grundrauschen_Modell mit ebenfalls vier Einträgen (Anmerkung: für jede in Frage kommende Antennenimpedanz F erhält man einen Modellvektor). Für die zwanzig Modellvektoren bildet man im R4-Raum der Transformationswege die euklidische Norm der Differenz zu den gemessenen Werten. Man wählt denjenigen Modellvektor mit dem kleinsten euklidischen Abstand im R4-Raum zum Messvektor aus. Die zu dem Modellvektor gehörige Antennenimpedanz ist dann die gesuchte unbekannte Antennenimpedanz Z_Ant.

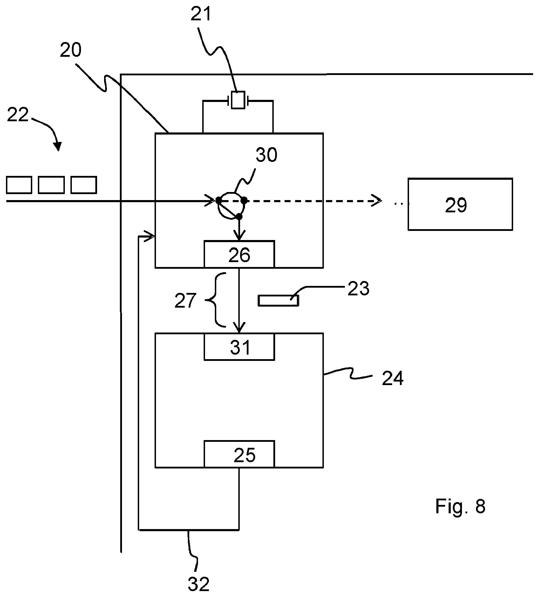

Die Messung der Rauschleistung bzw. Schätzung der Rauschzahl bei unterschiedlichen Anpassungen kann auch digital erfolgen, wie dies in Fig. 8 beispielhaft gezeigt ist.

Die analogen Eingangssignale (Datenpakete 22 oder Teile von Datenpaketen) werden nach dem Eingang in der Empfangseinrichtung bzw. dem Funkchip 20 z. B. mittels eines I/Q-Verfahrens (In-Phase/Quadrature-Verfahren) in digitale Daten verarbeitet. Dies kann beispielsweise dadurch erfolgen, dass das analoge Eingangssignal in zwei Signalteile aufgeteilt wird, wobei ein Signalteil mit der originalen Phasenlage (I-Daten) und der andere Signalteil z. B. um 90° phasenverschobener Referenzfrequenz (Q-Daten) erzeugt wird. Hierbei können digitale Daten z. B. über einen Schalter 30 aus dem Funkchip 20 bzw. RF-Frontend 19 abgezweigt und über eine Schnittstelle 27 einem Mikrokontroller 24 zugeführt werden, indem auf Basis dieser Daten 23 eine digitale Leistungsmessung z. B. in einem Microcontroller 24 vorgenommen werden kann. Die abgezweigten digitalen Daten bzw. digitalisierten Signale 23 werden somit nicht im Funkchip 20 oder einem nachgelagerten Dekoder 29 dekodiert, sondern dienen zur Bestimmung der Rauschleistung bzw. Schätzung der Rauschzahl. Der Funkchip verfügt über einen Taktgeber (Quarz) 21 sowie einen digitalen Filter 26.

Mittels des Filters 26, der am Funkchip 20 oder am Mikroprozessor 24 angeordnet sein kann, können die Daten z.B. gefiltert und einer Dezimierungseinheit 31 zugeführt werden. Dort wird über einen ganzzahligen Dezimationsfaktor ein Teil der Daten ausgewählt, die schließlich für die Bestimmung des Rauschfloors herangezogen werden. Zusätzlich kann der Mikrokontroller einen Speicher 25 aufweisen. Die Messdaten oder daraus abgeleitete Daten oder Informationen können über einen Rückkanal 32 dem Funkchip 20 wieder zugeführt werden, damit dort die Festlegung der entsprechenden Anpassung vorgenommen werden kann. Die einzelnen Funktionalitäten können im Funkchip 20 selbstverständlich auch zusammengefasst sein.

Der Empfänger kann auf diese Weise bei den unterschiedlichen Anpassungen an Hand der digitalen Daten (I/Q Daten), z. B. innerhalb eines Datenpakets, jeweils den Rauschfloor messen und die Messwerte oder daraus abgeleiteten Werte untereinander vergleichen. Die Anpassung mit dem günstigsten bzw. niedrigsten Rauschfloor bzw. der entsprechenden Rauschzahl wird ausgewählt. Diese Art der Rauschzahlfeststellung ist deutlich schneller und dazu in seiner Bestimmung erheblich flexibler. Die nicht abgezweigten Daten werden im Dekoder 29 dekodiert.

Beispielsweise ist es hierdurch möglich, innerhalb eines Datenpakets 22 z. B. mindestens zwei Empfangsgrundrauschzustände bei unterschiedlichen Anpassungen Z0, Z1, Zn zu vergleichen und eine Anpassung auszuwählen, bei der das Grundrauschen niedriger oder am niedrigsten ist. Die Bestimmung der Rauschzahlen F0, F1, Fn erfolgt hierbei über die vom Funkchip 20 stammenden I/Q-Daten 23. Der Funkchip 20 verfügt über eine Schnittstelle 27, an der dieser die I/Q-Daten 23 zur Weiterverarbeitung auf Basis eines sogenannten Software-Defined-Radio-Ansatzes bereitstellt. In dem Speicher 25 des Mikroprozessors 24 können die erforderlichen empirischen Vergleichsdaten abgelegt sein.

Das erfindungsgemäße Verfahren hat bietet den Vorteil, dass in einfacher Weise eine Störer Detektion bzw. Störer Überwachung durchgeführt werden kann. Wurde nämlich eine Impedanzeinstellung nicht verändert, obgleich sich das Grundrauschen trotzdem wesentlich verändert hat, deutet dies auf das Vorhandensein eines Störers hin. In diesem Fall wird die Schätzung des Grundrauschens unterbrochen und später fortgesetzt.

Da sich die Rauschleistung nach der Gaußkurve verhält, kann man hierzu als Abgrenzungskriterium eine Mittelung der Gaußkurve vornehmen und beispielsweise eine gewisse Abweichung davon (z. B. von +/- 2 Sigma) zulassen.

Auch hinsichtlich des Grenzbereichs kann eine Aufteilung vorgenommen werden, beispielsweise indem der Kanal durch eine PLL-Verstellung oder Frequenzzerlegung (DFT/FFT) in unterschiedliche Subkanäle geteilt wird. Wenn sich die empfangene Leistung in den einzelnen Kanälen stark voneinander unterscheidet, deutet das ebenfalls auf das Vorhandensein eines Störers hin.

Beispielsweise ist die höchste Rauschzahl des Empfängers (z.B. 20 dB) im System bekannt. Der zu erwartende Rauschgrund läge z. B bei einem System mit 20 kHz Bandbreite bei -131 dBm wie in Fig. 5 dargestellt. Mit 20 dB maximaler Rauschzahl kann die gemessene Leistung am Empfängerausgang jedoch maximal -111 dBm betragen. Somit deutet eine Messung einer Rauschleistung am Empfängerausgang von beispielsweise -100 dBm, auf das Vorhandensein eines Störers hin.

Das erfindungsgemäße Verfahren ermöglicht somit zudem auch eine wirksame Störer Erfassung.

**BEZUGSZEICHENLISTE**

| | |
|---|---|
| 1 | Knoten |
| 2 | Funkmodul |
| 3 | Antenne |
| 4 | Energiequelle |
| 5 | Sendepfad |
| 6 | Empfangspfad |
| 7 | PA (Power Amplifier) |
| 8 | LNA (Low Noise Amplifier) |
| 9 | TX-Modulationsglied |
| 10 | Datensammler |
| 11 | Mikroprozessor |
| 12 | Rausch-Anpassglied |
| 13 | Rausch-Anpasssglied |
| 14 | Rauschzahlschätzglied |
| 15 | Impedanz-Anpassglied |
| 16 | Speicher |
| 17 | Sensorelement |
| 18 | Objekt |
| 19 | RF Front-End |
| 20 | Funkchip |
| 21 | Taktgeber (Quarz) |
| 22 | Datenpaket |
| 23 | I/Q-Daten |
| 24 | Mikroprozessor |
| 25 | Speicher |
| 26 | Filter |
| 27 | Schnittstelle |
| 28 | Datenzentrale |
| 29 | Dekoder |
| 30 | Switch |
| 31 | Dezimierungseinheit |
| 32 | Rückkanal |
| G | Verstärkungsfaktor (Gain) |
| F | Rauschzahl |
| M | Transformationsweg |
| Z | Impedanzpunkt |

**Patentansprüche**

1. Verfahren zum Verbessern der Antennenanpassung eines funkkommunikationsfähigen Knotens (1), insbesondere einer Sensor- und/oder Aktoreinrichtung, eines Kommunikationsnetzwerkes mit einem mit einer Antenne (3) ausgestatteten Funkmodul (2) mit Sende- (5) und/oder Empfangspfad (6) und einer vorzugsweise energieautarken Energieversorgungseinrichtung (4), insbesondere Batterie, wobei die Antenne (3) eine Impedanz (Z_Ant) aufweist, **dadurch gekennzeichnet, dass**
bei unterschiedlichen Anpassungen (Transformationswege), vorzugsweise mittels eines einstellbaren oder schaltbaren Anpassnetzwerks, jeweils Rauschleistung im Empfangspfad (6) gemessen und daraus die Impedanz (Z_Ant) der Antenne (3) bestimmt oder zumindest geschätzt wird.

2. Verfahren nach Anspruch 1, **dadurch gekennzeichnet, dass** abhängig davon

   (a) die Rauschzahl (F0, F1, Fn) reduziert oder minimiert wird und/oder
   (b) die Sendeleistung im Sendefall erhöht oder maximiert wird und/oder
   (c) eine Umgebungsdetektion in Bezug auf den Empfang beeinflussender Gegebenheiten erfolgt.

3. Verfahren nach Anspruch 1 oder 2, **dadurch gekennzeichnet, dass**

   (a) ein Vergleich der gemessenen Rauschleistungswerte oder daraus abgeleiteter Werte untereinander erfolgt oder
   (b) ein Best-Fit-Verfahren durchgeführt wird, bei dem eine Bewertung der gemessenen Rauschleistungswerte oder daraus abgeleiteter Werte unter Einbeziehung empirischer oder vorbestimmter Werte, die als Bezug für die Bewertung dienen, erfolgt.

4. Verfahren nach einem der vorhergehenden Ansprüche, **dadurch gekennzeichnet, dass** eine Einstellung der Anpassung der Antenne (3) ausgewählt wird, zu der die gemessene Rauschleistung oder daraus abgeleitete Rauschzahl (F0, F1, Fn) unter der Annahme eines einheitlichen Verstärkungsfaktors am niedrigsten ist.

5. Verfahren nach einem der vorhergehenden Ansprüche, **dadurch gekennzeichnet, dass** der Rauschgrund von der gemessenen Rauschleistung abgezogen wird.

6. Verfahren nach einem der vorhergehenden Ansprüche, **dadurch gekennzeichnet, dass** ein Temperatur-bedingter Anteil der Rauschleistung mit berücksichtigt wird.

7. Verfahren nach einem der vorhergehenden Ansprüche, **dadurch gekennzeichnet, dass** die Ermittlung der Rauschleistung innerhalb einer ausgewählten Auflösungsbandbreite des Rauschens erfolgt.

8. Verfahren nach einem der vorhergehenden Ansprüche, **dadurch gekennzeichnet, dass** bei der Messung der Rauschleistung ein Verstärkungsfaktor (G0, G1, Gn) im Empfangspfad (6) fest eingestellt und/oder variiert wird.

9. Verfahren nach einem der vorhergehenden Ansprüche, **dadurch gekennzeichnet, dass** die Messung der Rauschleistung im Empfangspfad (6) nach oder am Ausgang eines Eingangsverstärkers oder LNAs (8) erfolgt.

10. Verfahren nach einem der vorhergehenden Ansprüche, **dadurch gekennzeichnet, dass** bei der Messung der Rauschleistung im Empfangspfad (6) eine Variation der Eingangsimpedanz eines Eingangsverstärkers oder LNA (8) mitberücksichtigt wird.

11. Verfahren nach einem der vorhergehenden Ansprüche, **dadurch gekennzeichnet, dass** die Messung der Rauschleistung im Empfangspfad (6) nach oder am Ausgang eines Eingangsverstärkers bzw. LNAs (8) erfolgt.

12. Verfahren nach einem der vorhergehenden Ansprüche 3 bis 11, **dadurch gekennzeichnet, dass** im Rahmen des Best-Fit-Verfahrens im Knoten gemessene Rauschleistungswerte mit vorher für eine Vielzahl von vorgegebenen Antennenimpedanz-Werten empirisch ermittelten und, vorzugsweise im Knoten, gespeicherten Rauschleistungswerten verglichen werden oder
dass im Rahmen des Best-Fit-Verfahrens im Knoten gemessene von der Impedanz der Antenne abhängige Parameter mit vorher für eine Vielzahl von vorgegebenen Antennenimpedanz-Werten empirisch ermittelten und, vorzugsweise im Knoten, gespeicherten entsprechenden Parametern verglichen werden.

13. Verfahren nach einem der vorhergehenden Ansprüche, **dadurch gekennzeichnet, dass** die Messung der Rauschleistung an digitalen Daten, vorzugsweise an sogenannten I/Q-Daten, insbesondere auf einem Mikrokontroller (24) erfolgt, wobei insbesondere vorgesehen ist, dass die digitalen Daten, vorzugsweise die I/Q-Daten, für die Messung der Rauschleistung von den zu dekodierenden digitalen Daten (Hauptdaten) abgezweigt werden und/oder Samples der digitalen Daten bzw. I/Q-Daten durch Dezimierung ausgewählt und diese für die Messung der Rauschleistung verwendet werden.

14. Verfahren nach Anspruch 13, **dadurch gekennzeichnet, dass** die Messung der jeweiligen Rauschleistung bei den einstellbaren Anpassungen der Antenne (3) bezogen auf ein Datenpaket (22) vorgenommen wird.

15. Verfahren nach einem der vorhergehenden Ansprüche, **dadurch gekennzeichnet, dass** die Antenne (3) am funkkommunikationsfähigen Knoten (1), vorzugsweise über eine lösbare Verbindung, austauschbar ist.

16. Funkkommunikationsfähiger Knoten (1), insbesondere Sensor- und/ oder Aktoreinrichtung, für den Einsatz in einem Kommunikationsnetzwerk mit einem mit einer Antenne (3) ausgestattetem Funkmodul (2) mit Sende-(5) und Empfangspfad (6) und einer vorzugsweise energieautarken Energieversorgungseinrichtung (4), insbesondere Batterie, sowie einem Impedanz-Anpassglied (15), **dadurch gekennzeichnet, dass** dieser mit einem Verfahren nach einem der vorhergehenden Ansprüche betrieben wird.

1

E, B, I

10

28

Fig. 1

18

A

3

1, 10

17

2

E, B, I

11

4

16

Fig. 2

Fig. 3

Fig. 4

Leistung/dBm

-131 dBm +R dB/20 kHz

-131 dBm/20 kHz

-174 dBm/Hz

R dB Rauschzahl

0 dB Rauschzahl

20 kHz

Frequenz/ Hz

Fig. 5

Fig. 6

Fig. 7

Fig. 8

Europäisches
Patentamt

European
Patent Office

Office européen
des brevets

## EUROPÄISCHER RECHERCHENBERICHT

Nummer der Anmeldung

EP 22 15 3915

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 9 935 798 B2 (COMMISSARIAT ENERGIE ATOMIQUE [FR] ET AL.) 3. April 2018 (2018-04-03) | 1-16 | INV. H04B17/21 |
| Y | * das ganze Dokument * | 2-15 | |
| | ----- | | |
| X | US 2008/129610 A1 (TSFATI YOSSI [IL] ET AL) 5. Juni 2008 (2008-06-05) | 1,16 | |
| Y | * das ganze Dokument * | 2-15 | |
| | ----- | | |

RECHERCHIERTE SACHGEBIETE (IPC)

H04B

Der vorliegende Recherchenbericht wurde für alle Patentansprüche erstellt

| Recherchenort | Abschlußdatum der Recherche | Prüfer |
|---|---|---|
| München | 21. Juni 2022 | Bohnhoff, Peter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 15 3915

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-06-2022

| Im Recherchenbericht angeführtes Patentdokument | Datum der Veröffentlichung | Mitglied(er) der Patentfamilie | Datum der Veröffentlichung |
|---|---|---|---|
| US 9935798 B2 | 03-04-2018 | EP 3182588 A1<br>FR 3045980 A1<br>US 2017180167 A1 | 21-06-2017<br>23-06-2017<br>22-06-2017 |
| US 2008129610 A1 | 05-06-2008 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016010045 A1